(19)
Europäisches
Patentamt
European
Patent Office
Office européen
des brevets

(11) **EP 2 355 168 A1**

(12) **EUROPEAN PATENT APPLICATION**
published in accordance with Art. 153(4) EPC

(43) Date of publication:
   **10.08.2011 Bulletin 2011/32**

(51) Int Cl.:
   ***H01L 31/042*** (2006.01)

(21) Application number: **09828986.1**

(22) Date of filing: **13.11.2009**

(86) International application number:
   **PCT/JP2009/069353**

(87) International publication number:
   **WO 2010/061738 (03.06.2010 Gazette 2010/22)**

(84) Designated Contracting States:
   **AT BE BG CH CY CZ DE DK EE ES FI FR GB GR
   HR HU IE IS IT LI LT LU LV MC MK MT NL NO PL
   PT RO SE SI SK SM TR**

(30) Priority: **28.11.2008 JP 2008303719
   05.01.2009 JP 2009000182**

(71) Applicant: **Toray Industries, Inc.
   Tokyo 103-8666 (JP)**

(72) Inventors:
   • **ARAI, Takashi**
   **Otsu-shi**
   **Shiga 520-8558 (JP)**
   • **NAKAJIMA, Ayuko**
   **Otsu-shi**
   **Shiga 520-8558 (JP)**
   • **HIROTA, Kusato**
   **Otsu-shi**
   **Shiga 520-8558 (JP)**

(74) Representative: **Hager, Thomas Johannes
   Hoefer & Partner
   Patentanwälte
   Pilgersheimer Straße 20
   D-81543 München (DE)**

(54) **FILM FOR BACKSIDE SEALING SHEET FOR SOLAR CELLS**

(57)    Disclosed is a film for a backside sealing sheet for solar cells, which has excellent light resistance and partial discharge voltage that serves as an index for electrical insulation. Also disclosed are a protective sheet for solar cell backside sealing and a solar cell module using the protective sheet. The film for a backside sealing sheet for solar cells is **characterized in that** a resin layer, which contains an antistatic agent and a resin that is obtained by copolymerizing an acrylic polyol resin with an ultraviolet absorbent and a light stabilizer, is arranged on at least one surface of a base film, and that the amount of the antistatic agent contained in the resin layer is 1-30 parts by mass per 100 parts by mass of the resin that is obtained by copolymerizing an acrylic polyol resin with an ultraviolet absorbent and a light stabilizer. Consequently, the film for a backside sealing sheet for solar cells can achieve more excellent light resistance and partial discharge voltage that serves as an index for electrical insulation than conventional films.

**EP 2 355 168 A1**

## Description

Technical field

The invention relates to a film for solar battery backside sealing sheet that has good characteristics, including light resistance and electrical insulating properties, to serve for long term use in a harsh outdoor environment, and also relates to a solar battery backside sealing sheet and a solar cell module made thereof.

Background art

In recent years, there has been greater fear for the depletion of fossil fuels including oil and coal, and there is pressing need to develop alternative energy sources to these fossil fuels. Accordingly, various methods for nuclear power generation, hydraulic power generation, wind power generation, and photovoltaic power generation have been studied, and some have been in actual use. Photovoltaic power generation, which can convert the energy of sunlight directly into electric energy, has been put to practical use as a new, pollution-free energy source that will be available virtually permanently. Its cost performance in practical use has been improved rapidly, making it a promising clean energy source.

Solar batteries used for photovoltaic power generation, which convert the energy of sunlight directly into electric energy, serve as the core portion of photovoltaic power generation systems, and they are made of semiconductors such as silicon. With respect to their structure, solar cell elements are arranged in series and/or in parallel and packaged in various ways into a unit to protect the elements for a time of 20 years or so. This packaged unit, which is called solar cell module, generally consists of a glass layer to cover the face that receives sunlight, a filler of thermoplastic resin to fill gaps, and a sealing sheet to protect the backside surface. For the thermoplastic resin filler, ethylene vinyl acetate copolymer resin (hereafter, EVA resin) is commonly used as they are high in transparency and moisture resistance. The backside sealing sheet, on the other hand, is not only required to have characteristics such as mechanical strength, weather resistance, heat resistance, water resistance, light resistance, chemical resistance, light reflectivity, moisture barrier properties, and thermal adhesion properties for bonding to EVA resin and other filler materials, but also need to have high light resistance because it is exposed to strong ultraviolet ray along with good electrical insulating properties to prevent short circuits in the solar battery system.

The materials conventionally used for backside sealing sheet film include white polyvinyl fluoride film (trade name: Tedlar (registered trademark), supplied by Du Pont Kabushiki Kaisha), and laminate-type backside sealing sheets consisting of a polyester film sandwiched between the above-mentioned films have been widely used for the present purpose. A laminate backside sealing sheet comprising a polyester-based film with high weather resistance and good gas barrier properties has also been proposed (Patent document 1). Furthermore, these solar battery backside sealing sheets are required to be resistant to a partial discharge voltage of 700V to 1,000V, depending on the generation capacity of the cells, to prevent the solar cell module from being damaged by the applied voltage, and there are some proposals for increasing the resistance to partial discharge voltage. For instance, films having electrical insulating properties or comprising a foamed layer have been proposed as a means of improving the partial discharge voltage (Patent document 2).

Prior art documents

Patent documents

Patent document 1: Japanese Unexamined Patent Publication (Kokai) No. 2002-100788
Patent document 2: Japanese Unexamined Patent Publication (Kokai) No. 2006-253264

Disclosure of the invention

Problems to be solved by the invention

However, though said polyvinyl fluoride films are highly weather resistant, they are low in mechanical strength, and can be softened by the heat of 140 to 150˚C applied during hot pressing for producing a solar cell module to allow projections in the electrodes of solar battery elements to penetrate the filler layer. Being high in price, furthermore, it is difficult to produce low-price solar cell modules comprising these films. With respect to electrical insulating properties, the partial discharge voltage of resin films depend on their thickness, and therefore, they tend to be so thick that workability in the cutting step will deteriorate and also that large costs will be required inevitably. If comprising a foamed layer as described in Patent document 2, such films containing a foamed layer will tend to undergo cleavage (coagulation destruction), leading to the problem of difficulty in achieving a high contact strength between the films bonded to each other. In some areas including Europe in recent years, solar cell modules are often installed obliquely from the ground, but in such cases, they are exposed to ultraviolet ray reflected from the ground for a long period of time. Consequently, the outer layer of the backside sealing sheet may be yellowed, causing deterioration in the appearance of the film, and in extreme cases, cracking may take place in the sealing sheet, causing deterioration in various other characteristics including electrical insulating properties and moisture barrier properties required for the sheet.

Means of solving the problems

To solve said problem, the film for solar battery backside sealing sheet of the invention has the following constitution:

(1) A film for solar battery backside sealing sheet comprising a resin layer containing a resin produced by copolymerizing an acrylic polyol resin, an ultraviolet absorber, and a photostabilizing agent, along with an antistatic agent, that is laminated to at least one side of a base film, wherein the antistatic agent in the resin layer accounts for 1 to 30 parts by mass relative to 100 parts by mass of the resin produced by copolymerizing an acrylic polyol resin, an ultraviolet absorber, and a photostabilizing agent

(2) A film for solar battery backside sealing sheet as described in paragraph (1) wherein said antistatic agent is a cationic antistatic agent and/or an inorganic solid conductive material

(3) A film for solar battery backside sealing sheet as described in paragraph (2) wherein said antistatic agent is an inorganic solid conductive material, and said solid conductive material consists of needle-like inorganic fiber provided on an electrically conductive layer

(4) A film for solar battery backside sealing sheet as described in paragraph (3) wherein said inorganic fiber is of titanium oxide

(5) A film for solar battery backside sealing sheet as described in any of paragraphs (1) to (4) wherein said resin layer contains at least one polyisocyanate resin selected from the group of aliphatic isocyanate resin, alicyclic isocyanate resin, and araliphatic isocyanate resin

(6) A solar battery backside sealing sheet comprising a film for solar battery backside sealing sheet as described in any of paragraphs (1) to (5) wherein said film is covered with at least one other film

(7) A solar battery backside sealing sheet as described in paragraph (6) wherein said at least one other film is formed on the opposite side to said resin layer side of a film for solar battery backside sealing sheet

(8) A solar cell module comprising a solar battery backside sealing sheet as described in paragraph (6) bonded to the silicon cell filler layer side of the solar cell module

Effect of the invention

According to the invention, it is possible to produce a film for solar battery backside sealing sheet that has a high light resistance and good electrical insulating properties.

According to a preferred embodiment of the invention, it is possible to produce a solar battery backside sealing sheet that can develop a strong contact with a silicon cell filler layer, have a high light reflectance, and improve the performance of a solar cell module.

Best mode for carrying out the invention

The film for solar battery backside sealing sheet of the invention has a higher light resistance and better electrical insulating properties compared to conventional ones as it comprises a resin layer containing a resin produced by copolymerizing an acrylic polyol resin, an ultraviolet absorber, and a photostabilizing agent, along with an antistatic agent, that is laminated to at least one side of a base film, wherein the antistatic agent in the resin layer accounts for 1 to 30 parts by mass relative to 100 parts by mass of the resin produced by copolymerizing an acrylic polyol resin, an ultraviolet absorber, and a photostabilizing agent.

[Base film]

Various resin films can be used as the base film of the film for solar battery backside sealing sheet of the invention. Specifically, they include polyester resin films such as polyethylene terephthalate (PET) and polyethylene naphthalate (PEN); other resin films such as polycarbonate, polymethyl methacrylate, polyacrylate, polypropylene, and polyethylene; and resin films of mixtures thereof. In particular, polyester resin films are preferable because of their strength, dimensional stability, and heat stability, and such polyester resin films as PET and PEN are particularly preferable because they are low in price. These polyester resins may be copolymers, and the usable copolymer components include, for instance, diol components such as propylene glycol, diethylene glycol, neopentyl glycol, and cyclohexanedimethanol; and dicarboxylic acid components such as isophthalic acid, adipic acid, azelaic acid, sebacic acid, and ester-forming derivatives thereof.

As the film for solar battery backside sealing sheet of the invention has a high light resistance, it can serve effectively as the outermost layer of a solar battery backside sealing sheet, which is directly exposed to outdoor air (humidity, temperature) and ultraviolet rays reflected from the ground surface. It is preferable that the base film is a highly hydrolysis resistant resin film considering the case where it is used as outmost layer directly exposed to outdoor air. Common polyester resin films are formed of a so-called polymer produced through condensation polymerization of monomers that contains oligomers, intermediate materials between monomer and polymer, up to about 1.5 to 2 mass%. Such oligomers are mainly cyclic trimmers, and films containing them up to a large content can suffer deterioration in mechanical strength and cracking and fracture caused by hydrolysis with rain water as they are exposed to outdoor air etc. for a long period of time. To provide a hydrolysis resistant film, on the other hand, a polyester resin film is produced from a polyester resin with a cyclic trimer content of 1.0 mass% or less synthesized through solid phase polymerization. Thus, hydrolysis can be depressed under high temperature, high humidity conditions, and the resulting film will be also high in heat resistance and weather resistance. To determine the cyclic trimer content, a solution of, for instance, 100 mg of a polymer dissolved in 2 ml of orthochlorophenol is used for liquid chromatography to measure its weight (wt%) relative to the weight of the resin.

The resin film may contain, for instance, additives such as antistatic agent, ultraviolet absorber, stabilizer, antioxidant, plasticizer, lubricant, filler, and color pigment, as needed, as long as they do not impair the effect of the invention.

The base films that can be used for the invention also include resin films produced from resins consisting of white pigments kneaded in a polyester resin such as polyethylene terephthalate (PET) and polyethylene naphthalate (PEN), and it is also preferable that they have said good hydrolysable properties. Such a white film is used with the aim of reflecting the light reaching the backside sheet in order to assist the energy conversion in the semiconductor element, and it is preferable that the film is provided in a layer near the cell. Such a white polyester film often used preferably as base film reflects sunlight to increase the power generation efficiency. The white polyester film preferably is a polyester film having a reflectance 50% or more for light with a wavelength, $\lambda$, of 550 nm. The polyester resin that constitutes the polyester resin film may be polyethylene terephthalate with ethylene terephthalate accounting for 80 mol% or more of the constituent units, polyethylene naphthalate with ethylene naphthalate accounting for 80 mol% or more of the constituent units, or polylactic acid resin with polylactic acid accounting for 80 mol% or more of the constituent units, though there are no specific limitations. Furthermore, the polyester resin may be a copolymer, and the usable copolymer components include, for instance, diol components such as propylene glycol, diethylene glycol, neopentyl glycol, and cyclohexanedimethanol, and dicarboxylic acid components such as isophthalic acid, adipic acid, azelaic acid, sebacic acid, and ester-forming derivatives thereof.

The usable white pigments include titanium oxide and zinc oxide, and they may be kneaded into a white resin film with a whiteness of 80% or more and an opacity of 80% or more.

There are no specific limitations on the thickness of the resin film, but it is preferably in the range of 25 to 250 $\mu$m in view of the dielectric strength, cost, and the like of the sealing sheet.

The base film may be a moisture barrier film comprising at least one inorganic oxide layer formed by deposition etc. with the aim of developing water vapor barrier properties. The "moisture barrier film" as referred to herein for the invention is a resin film with a moisture transmission coefficient of $5g/(m^2 \cdot day)$ or less as measured by the B method specified in JIS K7129 (2000). Such a moisture barrier film may be produced by, for instance, forming at least one inorganic oxide layer by deposition etc. on at least one surface of said polyester resin film such as polyethylene terephthalate (PET) and polyethylene naphthalate (PEN). The gas barrier properties of the film with an inorganic oxide layer formed by deposition etc. are attributed at least to the dimensional stability at high temperatures of the polyester resin film used as base material, and therefore, it is preferable that the polyester resin film is a biaxially stretched film.

Practically, the polyester resin film preferably used in said moisture barrier resin film preferably has a thickness in the range of 1 to 100 $\mu$m, more preferably 5 to 50 $\mu$m, and particularly preferably about 10 to 30 $\mu$m, from the viewpont of stability in the inorganic oxide layer formation step as well as production costs.

The inorganic oxides that can serve to constitute the inorganic oxide layer formed for the invention include, for instance, metal oxides and metal nitride oxides. The inorganic oxide layer can be produced by deposition, sputtering, ion plating, or plasma vapor deposition (CVD). From the viewpoint of productivity, however, vacuum deposition is the best method at the present time. It is preferable that the vacuum deposition equipment used for the vacuum deposition adopts electron beam heating, resistance heating, or induction heating as heating means. The usable metal oxides to constitute the inorganic oxide layer include, for instance, aluminum oxide, magnesium oxide, titanium oxide, oxidized tin, indium oxide alloy, and silicon oxide, while the usable metal nitride oxides include silicon oxynitride. In particular, inorganic oxides such as aluminum oxide, silicon oxide, silicon oxynitride, and mixtures thereof are used preferably from the viewpoint of moisture barrier properties and production efficiency.

Depending on the inorganic substance and constitution to be used, it is commonly preferable that the inorganic oxide layer has a film thickness in the range of 2 to 300 nm, more preferably 3 to 100 nm, and still more preferably 5 to 50 nm. If the film thickness is more than 300 nm, the layer, particularly in the case of a metal oxide layer, may suffer a decrease in flexibility, possibly leading to cracks, pinholes, etc., in the thin film caused by an external force of bending, stretching, etc., after the film production process (during post-processing steps etc.), which may cause serious deterioration in the moisture barrier properties. Furthermore, the growth rate of the inorganic layer will decrease, which may cause a decrease in productivity. If the film thickness is less than 2 nm, on the other hand, it will be difficult to form a uniform film, or the film may not be thick enough, possibly failing to develop sufficient moisture barrier properties.

The polyester resin film is preferably a biaxially stretched film because such polyester resin film will have a high dimensional stability at high temperatures. In addition, the polyester resin film may be subjected to discharge treatment such as corona discharge and plasma electrical discharge, and surface treatment such as acid treatment, as required.

[Resin layer]

The resin layer to be formed on the surface of the base film for the present invention consists of: (1) a resin produced by copolymerizing an acrylic polyol resin, an ultraviolet absorber, and a photostabilizing agent, and (2) an antistatic agent. Commonly, a resin layer with ultraviolet screening capability and improved light resistance is produced by adding one or more organic ultraviolet absorbers and/or inorganic ultraviolet absorbers to the binder resin, along with a photostabilizing agent (HALS) with the aim of increasing the photostability through a mechanism for deactivating radicals that could be excited by light. A resin layer produced by adding, in a later step, ultraviolet absorbers and photostabilizing agents to a binder resin, however, can suffer bleed-out of the ultraviolet absorbera and photostabilizing agents from inside the coat film to the surface of the coat film when exposed to a high temperature, high humidify environment and ultraviolet rays, leading not only to changes in the wettability and contact strength of the coat surface, but also the problem of losing the initially existing ultraviolet screening capability. The present invention, on the other hand, uses a binder resin that consists of an acrylic resin, which is relatively high in light resistance compared to polyester resins and olefin resins, copolymerized with an ultraviolet absorber and a photostabilizing agent. To improve the strength of contact with the base film and to form a highly heat resistant coat layer, which is exposed to high processing temperatures during the solar cell module production step, on the surface of the solar battery backside sealing sheet of the film for solar battery backside sealing sheet of the invention, it is particularly preferable to use acrylic polyol resin, which can be crosslinked appropriately, as compared to other acrylic resins.

As the copolymerizable monomers to fix the ultraviolet absorber and photostabilizing agent, it is preferable to use vinyl monomers, such as acrylic- or styrene-type, as they serve for various purposes and they are low in price. Of these copolymerizable monomers, styrene-type vinyl monomers can be easily yellowed because of the aromatic ring contained, while acrylic-type vinyl monomers are most preferable in terms of light resistance. Thus, at least one of the polymerizable monomer components to constitute the acrylic resin should be one or more unsaturated compounds selected from the group of unsaturated carboxylate, unsaturated carboxylic acid, unsaturated hydrocarbon, and vinyl ester.

The usable unsaturated carboxylates include methyl methacrylate, methyl acrylate, ethyl acrylate, ethyl methacrylate, n-propyl acrylate, n-propyl methacrylate, isopropyl acrylate, isopropyl methacrylate, n-butyl acrylate, n-butyl methacrylate, isobutyl acrylate, isobutyl methacrylate, t-butyl acrylate, t-butyl methacrylate, 2-ethylhexyl acrylate, and 2-ethylhexyl methacrylate.

The usable unsaturated carboxylic acids include acrylic acid, methacrylic acid, maleic acid, itaconate, crotonic acid, and fumaric acid.

The usable other monomers include butadiene, ethylene, and vinyl acetate. Unsaturated carboxylates are preferable. Of the unsaturated carboxylates, methyl methacrylates and methyl acrylates are particularly preferable in terms of general versatility, price, and photostability.

Described below is the polymerizable monomer to be used to form an acrylic polyol resin by introducing hydroxyl groups which act as stating points of crosslinking and serve to form a highly heat resistant coat film. The polymerizable monomer components that can be used to introduce a hydroxyl group into acrylic resin include, for instance, unsaturated monomers such as 2-hydroxyethyl acrylate, 2-hydroxyethyl methacrylate, 2-hydroxypropyl acrylate, 2-hydroxypropyl methacrylate, 2-hydroxybutyl acrylate, 2-hydroxybutyl methacrylate, 2-hydroxyvinyl ether, polyethylene glycol methacrylate, polypropylene glycol monoacrylate, and polypropylene glycol monomethacrylate. These unsaturated compounds having a hydroxyl group may be used singly or as a mixture of two or more thereof.

[Ultraviolet absorber]

The usable ultraviolet absorbers to be copolymerized with said acrylic polyol resin include those ultraviolet absorbers based on salicylic acid, benzophenone, benzotriazole, or cyanoacrylate. Specifically, they include, for instance, salicylic acid based ones such as p-t-butyl phenyl salicylate and p-octyl phenyl salicylate, benzophenone based ones such as 2,4-dihydroxybenzophenone, 2-hydroxy-4-methoxy benzophenone, 2-hydroxy-4-methoxy-5-sulfobenzophenone, 2,2',4,4'-tetrahydroxy benzophenone, bis(2-methoxy-4-hydroxy-5-benzoyl phenyl) methane, benzotriazole based ones such as 2-(2'-hydroxy-5'-methyl phenyl) benzotriazole, 2-(2'-hydroxy-5'-methyl phenyl) benzotriazole, 2,2'-methylene bis[4-(1,1,3,3-tetramethylbutyl) -6-(2Hbenzotriazole-2-yl) phenol], cyanoacrylate based ones such as ethyl-2-cyano-3,3'-diphenyl acrylate), and others such as 2-(4,6-diphenyl-1,3,5-triazine-2-yl) -5-[(hexyl) oxy]-phenol, along with modified or polymerized products and derivatives thereof.

[Photostabilizing agent]

Similarly, the usable photostabilizing agents to be copolymerized with said acrylic polyol resin include, for instance, those based on hindered amine. Specifically, they include bis(1,2,2,6,6-pentamethyl-4-piperidyl) [[3,5-bis(1,1-dimethylethyl)-4-hydroxyphenyl]methyl] butyl malonate, bis(1,2,2,6,6-pentamethyl-4-piperidyl) sebacate, methyl (1,2,2,6,6-pentamethyl-4-piperidyl) sebacate, decanedioic acid bis[2,2,6,6-tetramethyl-1-octyl oxy]-4-piperidinyl] ester, and modified or polymerized products and derivatives thereof.

For the invention, a resin produced by copolymerizing benzotriazole based or benzophenone based reactive monomers, together with hindered amine (HALS) based reactive monomers, is used preferably because such a resin absorbs ultraviolet rays efficiently even if it is in the form of a thin film.

A method etc. to produce a copolymer resin from a photostabilizing agent, an ultraviolet absorber, and an acrylic polyol is described in detail in paragraphs [0019] to [0039] of Japanese Unexamined Patent Publication (Kokai) No. 2002-90515. In particular, it is preferable to use HALS Hybrid (registered trademark) (supplied by Nippon Shokubai Co., Ltd.), which contains a copolymer of a acrylic monomer and an ultraviolet absorber as active elements.

[Antistatic agent]

For the invention, an antistatic agent is added with the aim of improving the partial discharge voltage of a film for solar battery backside sealing sheet. As described above, solar battery backside sealing sheets are required to have dielectric strength characteristics, and the partial discharge voltage is an essential item of the product specification. For individual solar cell modules, suitable components are specified to meet the operating system voltage, and solar battery backside sealing sheets with a higher partial discharge voltage can work in a wider range of solar cell modules. Addition of an antistatic agent to the coat layer improves the partial discharge voltage of the coat film, i.e. the film for solar battery backside sealing sheet. Though the mechanism of the partial discharge voltage improvement has not been clarified at the present time, it is likely that some contribution comes from the increased electric conductivity serving to leveling the electric potential over the film surface. To achieve an effective increase in the partial discharge voltage, it is preferable that the coat layer surface has a surface resistance in the range of from $1 \times 10^7 \Omega/cm$ to $5 \times 10^{12}$ $\Omega/cm$. It is more preferably in the range of $1 \times 10^7$ $\Omega/cm$ to $1 \times 10^{12}$ $\Omega/cm$, particularly preferably $1 \times 10^7$ $\Omega/cm$ to $1 \times 10^{10}\Omega/cm$.

If the surface resistance is less than $1 \times 10^7$ $\Omega/cm$, the resistance is too low and conduction phenomena can take place on the film surface, possibly leading to deterioration in the practical performance of the solar cell module. If the surface resistance is more than $5 \times 10^{12}$ $\Omega/cm$, on the other hand, the partial discharge voltage may not be increased effectively. It is inferred that this is because the electric potential is not leveled over the film surface as the partial discharge voltage develops.

The usable antistatic agents include, for instance, nonionic antistatic agents including polyhydric alcohols such as ethylene glycol, diethylene glycol, triethylene glycol, glycerin, trimethylolpropane, pentaerythritol, sorbit, and/or fatty acid esters thereof; polyethylene glycol and/or fatty acid esters thereof; and polyethylene glycol adducts and polypropylene glycol adducts of higher alcohol, polyhydric alcohol, or alkyl phenol.

In particular, glycerin fatty acid esters, polyethylene glycol and/or fatty acid esters thereof are used preferably as antistatic agent.

Polyhydric alcohol may be used without modification, but it is preferably esterified with a fatty acid in to a fatty acid ester.

There are no specific limitations on the fatty acid to be used, but saturated fatty acids such as lauric acid (C12), palmitic acid (C16), stearic acid (C18), and behenic acid (C22) and unsaturated fatty acids such as palmitoleic acid, oleic acid, erucic acid, and linoleic acid are preferable in terms of cost. Coconut oil fatty acid, soybean oil fatty acid, beef tallow fatty acid, sardine oil fatty acid, and naturally derived mixed fatty acids may also be used.

If polyhydric alcohol is esterified with these fatty acids, it is preferable that at least one hydroxyl group remains per molecular structure unit of the polyhydric alcohol.

If a polyethylene glycol and/or its fatty acid ester are used as antistatic agent, it is preferable that the polyethylene glycol contains 4 to 10,000 ethylene oxide repeating units, more preferably 100 to 8,000, and particularly preferably 1,000 to 6,000.

Polyethylene glycol may be used without modification as antistatic agent, but if it is converted into a fatty acid ester, the terminal hydroxyl group either may, or may not, remain.

If a polyethylene glycol adduct or a polypropylene glycol adduct of a higher alcohol is used as antistatic agent, there are no specific limitations on the higher alcohol as long as it has a carbon number of 6 or more, but the major industrially available ones include primary alcohols such as nonyl alcohol, decyl alcohol, lauryl alcohol, myristyl alcohol, cetyl alcohol, stearyl alcohol, and oleyl alcohol.

Mixtures with sperm alcohol or jojoba alcohol, and higher alcohols prepared by reduction such as beef tallow alcohol and palm alcohol may also be used.

If a polyethylene glycol adduct or a polypropylene glycol adduct of an alkyl phenol is used as antistatic agent, the alkyl phenol to be used may be, for instance, nonyl phenol, dodecyl phenol, octyl phenol, and octyl cresol.

If an ionic antistatic agent is to be used as said antistatic agent, the usable ionic antistatic agents include, for instance, anionic antistatic agents including sulfonate based antistatic agents such as alkyl sulfonate, alkyl benzene sulfonate, alkyl naphthalene sulfonate, and alkyl diphenyl sulfonate, and phosphorus based antistatic agents such as alkyl phosphate, alkyl phosphite, alkylphosphonic acid salt, and alkyl phosphonate acid ester; and cationic antistatic agents such as quaternary ammonium chloride, quaternary ammonium sulfate, and quaternary ammonium nitrate. Usable nonionic antistatic agents are also available. All these ionic and nonionic antistatic agents may be used effectively, and the preferable commercial anionic antistatic agents include, for instance, Plysurf (registered trademark) M208F supplied by Dai-Ichi Kogyo Seiyaku Co., Ltd., and Persoft (registered trademark) EDO and Persoft (registered trademark) EL supplied by NOF Corporation. The preferable commercial cationic antistatic agents include, for instance, Nopcostat (registered trademark) SN A-2, supplied by San Nopco Limited, Catiogen (registered trademark) ES-L supplied by Dai-Ichi Kogyo Seiyaku Co., Ltd., Elegan (registered trademark) 264WAX supplied by NOF Corporation, Futargent (registered trademark) 310 supplied by Neos Co., Ltd., and Elecond (registered trademark) PQ-50B supplied by Soken Chemical & Engineering Co., Ltd. The preferable commercial nonionic antistatic agents include, for instance, Noigen (registered trademark) TDS-30 and Noigen (registered trademark) ET-189 supplied by Dai-Ichi Kogyo Seiyaku Co., Ltd.

A resin layer may also be made antistatic by adding a conductive polymer as electrically conductive component. The usable conductive polymers include polyacetylene-, polypyrrole-, polythiophene-, and polyaniline-based polymers.

If these organic antistatic agents, ionic/nonionic antistatic agents, and conductivity polymers are used singly or as a mixture of two or more thereof as said antistatic agent, their content should be 1 to 30 parts by mass relative to 100 parts by mass of the resin produced by copolymerizing an acrylic polyol resin, an ultraviolet absorber, and a photostabilizing agent. It is more preferably 5 to 25 parts by mass relative to 100 parts by mass of the resin. If it is less than 1 part by mass, the antistatic agent materials will not able to form conductive networks sufficiently, failing to make the resin sufficiently antistatic. If the antistatic agent content is more than 30 parts by mass, on the other hand, the resin content in the resin layer becomes very low, and the ultraviolet screening performance will deteriorate largely, not only causing the coat film to decrease in flexibility and increase in brittleness, but also causing a decrease in the strength of contact with the base film. In addition, the antistatic agent material itself will be yellowed as it is exposed to ultraviolet ray irradiation, possibly leading to a decline in the film appearance, and thus the characteristics of the coat film will deteriorate.

Furthermore, conductive particles including carbon- or metal-based materials, and fillers including inorganic solid conductive materials may be used after ultraviolet ray irradiation in order to maintain the initial partial discharge voltage. These materials include carbon-based ones such as carbon black, graphite, fullerene, and carbon nanotube; and inorganic oxide compounds such as indium oxide, zinc oxide, oxidized tin, potassium titanate, and titanium oxide with their surface coated with a conductive substance such as tin-antimony-based oxide, indium-tin-based oxide, and antimony-tin-based oxide. In particular, inorganic solid conductive substances of a needle-like shape are preferable. The known needle-like conductive materials include carbon fibers and metal fibers. In particular, the use of fiber-like form of titanium oxide, which is useful as highly stable reinforcing material, serves to improve the reinforcing capability for increasing the strength of the coat film and enhance the effect in making the coat film highly conductive. When needle-like conductive materials are compared with spherical conductive materials, needle-like ones are preferable because needles can come in contact with each other more effectively when the same amount of the materials is added to the resin layer. Therefore, if the same amount is used, they can produce a higher partial discharge voltage than spherical ones. This means that sufficient conductive networks can be formed with a smaller amount of conductive material, and an equivalent or more partial discharge voltage can be obtained as compared with the use of spherical conductive materials. Furthermore, the use of a needle-like conductive material serves to decrease the content of conductive material in the coat film, while the resin produced by copolymerizing an acrylic polyol resin, an ultraviolet absorber, and a photostabilizing agent can account for a larger part in the coat film to increase the light resistance, allowing the coat film to improve in terms of both partial discharge voltage and light resistance.

An example of highly preferred needle-like conductive material is fiber-like titanium oxide with its surface coated with a conductive metal compound. Such metals used for coating the surface include antimony, indium, and niobium, and a preferable material may have a coat layer in which one or more compounds of these metals account for 1 to 30 wt% while tin oxide virtually accounts for the remainder. If the total content of antimony, indium, and niobium in the coat layer less than 1 wt%, it is not preferable because the doping will not have sufficient effect and it will be difficult to achieve a high conductivity. There are no specific limitations on the upper limit, but the conductivity will no longer improve as the content exceeds 30 wt%, making it unnecessary to waste these commonly expensive materials. The materials may fail to cover the surface of the needle-like titanium oxide uniformly, leading insufficient electric conductivity if their amount is too small, while they will form massive particles or grains on the surface and a uniform coat layer will not be formed, failing to develop a sufficient conductivity and shape characteristics, if their amount is too large. Thus, it is preferable that they account for a total of about 5 to 70 wt%. A method etc. for producing such needle-like inorganic solid conductive material is described in detail in paragraphs [0019] to [0022] of Japanese Unexamined Patent Publication (Kokai) No. HEI-07-53217. Specifically, a useful example is Dentol (registered trademark) WK-500B, a conductive ceramic material supplied by Otsuka Chemical Co., Ltd.

If an inorganic conductive material is added to the resin layer with the aim of making it antistatic, its content should be 1 to 30 parts by mass relative to 100 parts by mass of the resin produced by copolymerizing an acrylic polyol resin, an ultraviolet absorber, and a photostabilizing agent. It is more preferably 5 to 25 parts by mass relative to 100 parts by mass of the copolymer resin. If the content of the inorganic conductive material is less than 1 part by mass, the material will fail in developing sufficient conductive networks, and a sufficiently high antistatic performance will not develop. If the content of the inorganic conductive material is more than 30 parts by mass, on the other hand, the resin content in the resin layer will decrease largely, not only causing the coat film to decrease in flexibility and increase in brittleness, but also causing a decrease in the strength of contact with the base film. Thus the characteristics of the coat film will deteriorate.

Also, when an inorganic conductive material is used in combination with an organic antistatic agent such as organic compound type antistatic agent, ionic antistatic agent, or conductive polymer compound, their total content should be 1 to 30 parts by mass, preferably 5 to 25 parts by mass, relative to 100 parts by mass of the resin produced by copolymerizing an acrylic polyol resin, an ultraviolet absorber, and a photostabilizing agent. If the content is less than 1 part by mass, the material will not form sufficient conductive networks, failing to develop adequate antistatic characteristics. If the content of the inorganic conductive material is more than 30 parts by mass, on the other hand, the resin content in the resin layer will decrease largely, not only causing the coat film to decrease in flexibility and increase in brittleness, but also causing a decrease in the strength of contact with the base film. Thus the characteristics of the coat film will deteriorate.

Of the various antistatic agents and conductive materials listed above, inorganic solid conductive substances and cationic antistatic agents such as quaternary ammonium chloride, quaternary ammonium sulfate, and quaternary ammonium nitrate are preferable from the viewpoint of their heat resistance and moist heat resistance, and inorganic solid conductive substances are particularly preferable in view of their ultraviolet resistance in addition to moist heat resistance.

The various antistatic agents and conductive materials listed above may be used singly or as a mixture of two or more thereof to meet specific purposes.

[Crosslinking agent for acrylic polyol]

As described above, a crosslinking agent with a functional group that can react with the hydroxyl group in the acrylic polyol may be added with the aim of improving the characteristics of the resin layer.

If a crosslinking agent is used in combination, it will serve to improve the contact strength between the base film and the resin layer, and also improve the solvent resistance and heat resistance of the resin layer as a result of the introduction of crosslinked structures. In particular, when a solar battery backside sealing sheet is designed to use the resin layer of the invention as the outermost layer, the resin layer should have a particularly high heat resistance because it will be exposed to high temperatures up to a maximum of about 150°C for a long period of time of up to 30 minutes or longer during the solar cell module production process, specifically during the glass lamination step (cell filling step). During the solar cell module production process, solvent resistance is also required as the cleaning step following the module assembly step includes wiping with ethanol or other organic solvents. From the viewpoint of improving the contact strength, solvent resistance, and heat resistance, the use of a crosslinking agent is preferable, and a crosslinking agent should be added taking into consideration of the balance between improvement in the partial discharge voltage and improvement in the contact strength, solvent resistance, and heat resistance. If an organic conductive material is used as antistatic agent, it is preferable in most cases to avoid the addition of a crosslinking agent in order to maintain a high partial discharge voltage required for a film for solar battery backside sealing sheet. If a needle-like inorganic conductive material is used as crosslinking agent, on the other hand, not only a high partial discharge voltage required for a film for solar battery backside sealing sheet can be achieved easily, but also a high contact strength can be maintained, despite a decrease in the partial discharge voltage caused by the addition of the crosslinking agent.

The present invention uses a resin produced by copolymerizing an acrylic polyol resin, an ultraviolet absorber and a photostabilizing agent, and therefore, it is possible to use a crosslinking agent that can react with the hydroxyl group contained in the resin. In particular, it is preferable to use polyisocyanate resin as curing agent to accelerate the formation of urethane bonds (crosslinked structure). The polyisocyanates that serve as crosslinking agent include aromatic polyisocyanates, araliphatic polyisocyanates, alicyclic polyisocyanates, and aliphatic polyisocyanates, and the resin to be used may be produced from the diisocyanate compounds listed below.

Aromatic polyisocyanates may be produced from such diisocyanates as m- or p-phenylene diisocyanate, 4,4'-diphenyl diisocyanate, 1,5-naphthalene diisocyanate (NDI), 4,4'-, 2,4'- or 2,2'-diphenyl methane diisocyanate (MDI), 2,4- or 2,6-tolylene diisocyanate (TDI), and 4,4'-diphenyl ether diisocyanate.

Araliphatic polyisocyanates may be produced from such diisocyanate as 1,3- or 1,4-xylylene diisocyanate (XDI) and 1,3- or 1,4-tetramethyl xylylene diisocyanate (TMXDI).

Alicyclic polyisocyanate may be produced from such diisocyanates as 1,4-cyclohexane diisocyanate, 1,3-cyclohexane diisocyanate, 3-isocyanate methyl-3,5,5-trimethyl cyclohexyl isocyanate (isophorone diisocyanate ; IPDI), 4,4'-, 2,4'- or 2,2'-dicyclohexyl methane diisocyanate (hydrogenated MDI), methyl-2,4-cyclohexane diisocyanate, methyl-2,6-cyclohexane diisocyanate, and 1,3- or 1,4-bis(isocyanate methyl)cyclohexane (hydrogenated XDI).

Aliphatic polyisocyanates may be produced from such diisocyanates as trimethylene diisocyanate, tetramethylene diisocyanate, hexamethylene diisocyanate (HDI), pentamethylene diisocyanate, 1,2-propylene diisocyanate, 1,2-, 2,3- or 1,3-butylene diisocyanate, and 2,4,4- or 2,2,4-trimethyl hexamethylene diisocyanate.

A polyisocyanate can be produced from a mixture of two or more of these diisocyanates. In this case, it is preferable to use at least one polyisocyanate resin selected from the group of aliphatic isocyanate resin, alicyclic isocyanate resin and araliphatic isocyanate resin, because resins with a skeleton containing an aromatic ring that has a light absorption band in the ultraviolet region are easily yellowed when irradiated with ultraviolet rays. Furthermore, it is preferable to use a curing agent consisting mainly of an aliphatic polyisocyanate because it will suffer less deterioration in the adhesive strength when exposed to ultraviolet rays.

[Coating of resin layer]

The resin layer of the invention preferably has a thickness of 0.2 to 5 $\mu$m, more preferably 1 to 4 $\mu$m, and still more preferably 3 to 4 $\mu$m. In the case where this resin layer is formed by coating, phenomena such as cissing and film breakage can take place during the coating process if a resin layer with a thickness less than 0.2 $\mu$m is to be formed. It will be difficult to produce a uniform coat film, possibly failing to develop a sufficient strength of contact with the base film and in particular failing to achieve a sufficient ultraviolet screening capability. If a resin layer with a thickness of more than 5 $\mu$m is to be produced, on the other hand, a sufficient ultraviolet screening capability will be developed, but there will be limitations on the coating method to be used (special process or equipment to perform thick coating), and high production costs will be required. In addition, other disadvantages such as adhesion of the coat film to the rolls used for transportation may occur, possibly leading to peeling of the coat film.

If the resin layer of the invention is to be formed by coating, the solvents that can serve to prepare a coating liquid include, for instance, toluene, xylene, ethyl acetate, butyl acetate, acetone, methyl ethyl ketone, methyl isobutyl ketone, tetrahydrofuran, dimethyl formamide, dimethyl acetamide, methanol, ethanol, and water, and the coating liquid to be used may be either in the form an emulsion or a solution.

There are no specific limitations on the method to be used to form a resin layer on the base film, and a generally known coating method may be used. The various usable methods include, for instance, roll coating, dip coating, bar coating, die coating, gravure roll coating, and combinations thereof. Of these, gravure roll coating is preferable because the composition for coat layer formation can be highly stabilized.

[Solar battery backside sealing sheet]

A solar battery backside sealing sheet can be produced by laminating a film for solar battery backside sealing sheet produced according to the invention to another resin film, and the generally known dry lamination method can be used to combining the films into a sheet. For combining the resin films by dry lamination, it is possible to use a generally known adhesive for dry lamination that consists of a base resin such as polyether poly polyurethane, polyester polyurethane, polyester, and polyepoxy resin, and a curing agent of polyisocyanate resin. The adhesive layer of these adhesives, however, should not suffer delamination as a result of deterioration in the adhesive strength attributed to long term outdoor use, or undergo yellowing that could lead to a decrease in the light reflectance. The adhesive layer preferably has a thickness in the range of 1 to 5 $\mu$m. An adequate adhesive strength may not be achieved if it is less than 1 $\mu$m. If it is more than 5 $\mu$m, on the other hand, it is not preferable because the adhesive application speed cannot be increased, and a long aging time will be necessary to develop a required adhesive strength (to accelerate the crosslinking reaction between the base resin and the curing agent). Furthermore, a large amount of the adhesive will be required, and all these will lead to increased production costs.

A generally known adhesive for dry lamination can be used as material to form an adhesive layer necessary for the invention. A common adhesive for dry lamination consists of two resins, i.e. base resin and crosslinking agent, diluted and adjusted with a diluent solvent. The crosslinking agent to be used is preferably a polymer containing an isocyanate group, which may be high in reactivity with active hydroxyl groups and also high in reaction rate and can develop an initial contact strength quickly. In addition to these advantages, it serves to produce an adhesive resin layer that is high in the adhesive strength to the base film, and the adhesive strength is maintained stably at high temperatures durably for a long period of time. The base resin to be used with this polymer containing an isocyanate group may be, for instance, a polyether-, polyester-, or polyol-based urethane resin or an epoxy resin, and an appropriate one may be selected to meet the detailed required characteristics and processing conditions. Depending on the constitution of the solar battery backside sealing sheet, it is likely that ultraviolet rays can reach the adhesive layer to cause degradation of the resin. From this viewpoint, the resin to be used to form the adhesive layer is preferably an aliphatic resin or an alicyclic resin in which aromatic rings do not exist or account for a very small part.

The solar battery backside sealing sheet is required to have various characteristics including, for instance, moisture barrier properties, light reflectivity, long term moist heat resistance and light resistance, high contact strength with cell fillers, and electrical insulating properties. To meet these required characteristics, efforts are being made in the industrial sector to provide various sheet designs (laminate designs) that combine different functional films with processing techniques such as deposition and wet coating, based on the concept of functional partition.

According to the invention, protect sheets for solar battery backside sealing that meet various required characteristics can be produced by combining the film for solar battery backside sealing sheet of the invention with one or more films that are selected from the following group but different from the base film: a hydrolysis resistant film, a white film, a film with a deposited inorganic oxide layer, or a film that can be heat-bonded to EVA. In particular, that portion of the solar battery backside sealing sheet which is exposed when built in a solar cell module should preferably be formed of a hydrolysis resistant, light resistant film that consists of a hydrolysis resistant film as described above, which serves as base film, and the resin layer of the invention formed on the base film. The use of a hydrolysis resistant film serves to prevent the inner layers (adhesive layer, film layer, etc.) from being hydrolyzed. In addition, a film with an ultraviolet screening capability is used to form the outermost layer to protect the inner layers from ultraviolet rays. It is preferable, on the other hand, that one or more of the group of a white film, a film with a deposited inorganic oxide layer, and a film that can be heat-bonded to EVA is laminated to the opposite side of the base film to the resin layer side. The white film may be, for instance, Lumiror MX01 and E20F polyethylene terephthalate films supplied by Toray Industries, Inc., Tedlar PV2001 polyvinyl fluoride film supplied by Du Pont Kabushiki Kaisha, Kynar 302-PGM-TR polyvinylidene fluoride film supplied by Arkema K.K. The film with a deposited inorganic oxide layer may be, for instance, Barrier-Locks 1011HG and 1011HGTSCR supplied by Toray Advanced Film Co., Ltd., which consist of a deposited inorganic oxide layer of aluminum oxide formed on a base film of polyethylene terephthalate. The film that can be heat-bonded to EVA may be, for instance, Torayfan NO ZK93K 4801 and 4806 polyolefin films supplied by Toray Advanced Film Co., Ltd. The white film works to form a light reflective layer, and the film with a deposited inorganic oxide layer acts to develop moisture barrier properties. The film that can be heat-bonded to EVA serves to enhance the strength of contact with cell filler layers. Furthermore, not only one but two or more films that meet various required characteristics may be laminated to the film for solar battery backside sealing sheet of the invention to provide solar battery backside sealing sheets of intended designs.

In its constitution, the solar battery backside sealing sheet may contain a deposited layer, sputtered layer, wet coating layer, and the like to develop specific functions, at any position other than on the resin layer of the invention.

Examples

The film for solar battery backside sealing sheet of the present invention and the solar battery backside sealing sheet produced thereof will now be illustrated in greater detail with reference to Examples. The term "part(s)" as referred to herein means "part(s) by mass" unless specified otherwise.

< Methods for characteristics evaluation >

The methods used for characteristics evaluation for the invention are as described below.

(1) Measurement of coating weight

To determine the coating weight for the light resistant coat layer (resin layer), a resin layer was coated and a test piece with an area of 500 cm$^2$ was cut out, followed by measuring its mass, which is referred as mass (1). From the test piece, the resin layer was dissolved and removed in methyl ethyl ketone, and the mass of the test piece was measured, which is referred as mass (2). Subsequently, the coating weight per unit area was calculated by the following formula. Measurements were made for three test pieces, and their average was taken for evaluation.

$$\text{Formula: Coating weight } [\text{g/m}^2] = \{(\text{mass (1)}) - (\text{mass (2)})\} \times 20$$

(2) Evaluation for solvent resistance

To evaluate the solvent resistance of a light resistant coat layer, a test piece was immersed in ethanol for 5 minutes, and subsequently rubbed 50 times with Kimwipe (registered trademark), followed by measuring the partial discharge voltage. The appearance of the coat film was visually observed, and evaluated as follows.

○: no change found in treated coat film

×: peeling found between base material and coat film

(3) Measurement of water vapor transmittance

Measurements were made using water vapor transmittance measure equipment (Model: Permatran (registered trademark) W3/31 supplied by Mocon, Inc., U.S.A.) under the conditions of a temperature 40˚C and a humidity 90% RH according to the B method (infrared sensing) specified in JIS K7129 (2000). A measurement of water vapor transmittance was made for each of two test pieces, and their average was taken for evaluation.

(4) Evaluation for ultraviolet screening capability (spectroscopic measurement)

To evaluate the ultraviolet screening capability of the film for solar battery backside sealing sheet, spectroscopic analysis was carried out with a UV-Vis-NIR spectrophotometer (UV-3150 supplied by Shimadzu Corporation) according to JIS K 7105 (2006). The light screening capability in the ultraviolet region was evaluated based on transmittance measurements at a wavelength of 360 nm.

(5) Evaluation for strength of contact between base film and coat layer (resin layer)

To evaluate the strength of contact (coat layer contact strength) between the base film and the coat layer in a film for solar battery backside sealing sheet prepared, test pieces were subjected to crosscut test according to the method described in JIS K 5400 (1990), and evaluated according to the following criterion.

○: 100 out of 100 squares remaining

Δ:81 to 99 out of 100 squares remaining

×: 80 or less out of 100 squares remaining

(6) Measurement of surface resistance

The surface resistance was measured with a surface resistivity meter (MCP-HT450 supplied by Mitsubishi Chemical Corporation) in an environment of 23˚C and 65%RH. For test pieces with a coat layer (resin layer), measurements were made with the probe electrode held in contact with the coat surface. A measurement was made for each of three test pieces, and the average of the surface resistance measurements was taken for evaluation.

(7) Measurement of partial discharge voltage

The partial discharge voltage was measured with a partial discharge tester (KPD2050 supplied by Kikusui Electronics Corp.) in an environment of 23˚C and 65%RH. For test pieces with a coat layer (resin layer), measurements were made with a voltage applied to the coat layer surface. For test pieces free from a coat layer (resin layer), measurements were made with a voltage applied to the base film surface. A measurement was made for each of five test pieces. The maximum and minimum values were removed, and the average of the remaining partial discharge voltage measurements was taken for evaluation.

(8) Evaluation for ultraviolet resistance

Test pieces were irradiated with ultraviolet rays with a strength of 100 mW/cm$^2$ for 72 hours in an environment of 60˚C and 50%RH, and the b-value in the color system was measured with a ultraviolet tester (Eye Super UV Tester SUV-W151 supplied by Iwasaki Electric Co., Ltd.). For test pieces of the film for solar battery backside sealing, the ultraviolet screening capability and the contact strength between the base film and the coat resin were measured to evaluate the effect of ultraviolet irradiation on these characteristics.

(9) Evaluation for moist heat resistance

Test pieces of the film for solar battery backside sealing sheet were heat-treated for 48 hours in an environment of 120˚C and 100% RH in a pressure cooker (TPS-211 supplied by Espec Corp.). Subsequently, the test pieces of the film for solar battery backside sealing sheet were subjected to measurement of (8) the ultraviolet resistance and (5) the contact strength between the base film and the coat resin to evaluate the effect of moist heat treatment on these characteristics.

(10) Light reflectance

Solar battery backside sealing sheets were produced and used to prepare pseudo solar cell module samples. Light was applied to the glass side, and the light reflectance of the inner side surface of the backside sealing sheet (opposite side of the base film to the coated side) was measured with a spectrophotometer (MPC-3100 supplied by Shimadzu Corporation). To represent the reflectance, reflectance measurements at a wavelength of 600 nm were shown. The pseudo solar cell module samples used for the test were prepared by laminating an EVA sheet to the inner side surface of a backside sealing sheet produced (opposite side of the base film to the coated side), further laminating a 0.3 mm thick semi-reinforced glass on top of it, vacuuming it using a commercially available glass laminator, and pressing it for 15 minutes under a load of 3 Kgf/cm$^2$ at an elevated temperature of 135˚C. EVA sheets with a thickness of 500 μm supplied by Sanvic Inc. were used.

(11) Measurement of adhesive strength to filler

The adhesive strength to EVA sheets was measured according to JIS K 6854. The pseudo solar cell module samples used for the test were prepared by laminating an EVA sheet to the inner side surface of a backside sealing sheet produced (opposite side of the base film to the coated side), further laminating a 0.3 mm thick semi-reinforced glass on top of it, vacuuming it using a commercially available glass laminator, and pressing it for 15 minutes under a load of 3 Kgf/cm$^2$ at an elevated temperature of 135˚C. EVA sheets with a thickness of 500 μm supplied by Sanvic Inc. were used. Test pieces with a width of 10 mm were used for the adhesive strength test. A measurement of adhesive strength was made for each of two test pieces, and their average was taken for evaluation. An adhesive strength of 100 N/50 mm or more was assumed to be practically acceptable.

(Preparation of paint 1 for coat layer formation)

A mixture of 100 parts by mass of HALS Hybrid Polymer (registered trademark) BK1 (supplied by Nippon Shokubai Co., Ltd., solid content of 40 mass%), which is a coating material consisting of an acrylic polyol resin crosslinked with an ultraviolet absorber and a photostabilizing agent (HALS), 5 parts by mass of an antistatic agent, specifically a cationic antistatic agent of a hexafluoropropene derivative (Futargent (registered trademark) 310 supplied by Neos Co., Ltd.), 5 parts by mass of an aliphatic polyisocyanate resin (Desmodur (registered trademark) N3200 supplied by Sumika Bayer Urethane Co., Ltd., solid content of 100 mass%), and 140 parts by mass of ethyl acetate was weighed out and stirred for 15 minutes to prepare paint 1 for coat layer formation with a solid content (solid resin content) of 20 mass%.

(Preparation of paint 2 for coat layer formation)

Except that 10 parts by mass of Elecond (registered trademark) PQ-50B supplied by Soken Chemical & Engineering Co., Ltd., which is a cationic antistatic agent of a cationic acrylic polymer, was used as said antistatic agent, the same procedure as for the preparation of paint 1 for coat layer formation was carried out to provide paint 2 for coat layer formation.

(Preparation of paint 3 for coat layer formation)

Except that 20 parts by mass of Sankonol (registered trademark) PEO-20R supplied by Sanko Chemical Industry Co., Ltd., which is a cationic antistatic agent consisting of a polyol resin and a lithium salt, was used as said antistatic agent, the same procedure as for the preparation of paint 1 for coat layer formation was carried out to provide paint 3 for coat layer formation.

(Preparation of paint 4 for coat layer formation)

Except that 10 parts by mass of Elecond (registered trademark) PQ-50B supplied by Soken Chemical & Engineering Co., Ltd., which is a cationic antistatic agent, and 10 parts by mass of Sankonol (registered trademark) PEO-20R supplied by Sanko Chemical Industry Co., Ltd., which is a cationic antistatic agent consisting of a polyol resin and a lithium salt, were used as said antistatic agent, the same procedure as for the preparation of paint 1 for coat layer formation was carried out to provide paint 4 for coat layer formation.

(Preparation of paint 5 for coat layer formation)

Except that the aliphatic polyisocyanate resin was not used and that 120 parts by mass of ethyl acetate with a solid content (solid resin content) of 20 mass% was added, the same procedure as for the preparation of paint 1 for light resistant coat layer formation was carried out to provide paint 5 for coat resin layer formation.

(Preparation of paint 6 for coat layer formation)

Except that 7 parts by mass of Dentol (registered trademark) WK-500 supplied by Otsuka Chemical Co., Ltd., which is an antistatic agent of a needle-like inorganic solid oxide, was added as said antistatic agent, together with 148 parts by mass of ethyl acetate, the same procedure as for the preparation of paint 1 for coat layer formation was carried out to provide paint 6 for coat layer formation.

(Preparation of paint 7 for coat layer formation)

Except that the aliphatic polyisocyanate resin was not used and that 128 parts by mass of ethyl acetate with a solid content (solid resin content) of 20 mass% was added, the same procedure as for the preparation of paint 6 for light resistant coat layer formation was carried out to provide paint 7 for coat resin layer formation.

(Preparation of paint 8 for coat layer formation)

Except that Futargent (registered trademark) 310 supplied by Neos Co., Ltd., which is a cationic antistatic agent, was not used, the same procedure as for the preparation of paint 1 for coat layer formation was carried out to provide paint 8 for coat layer formation.

(Preparation of paint 9 for coat layer formation)

Except that 0.5 part by mass of Futargent (registered trademark) 310 supplied by Neos Co., Ltd., which is a cationic antistatic agent, was added as said antistatic agent, the same procedure as for the preparation of paint 1 for coat layer formation was carried out to provide paint 9 for coat layer formation.

(Preparation of paint 10 for coat layer formation)

Except that 35 parts by mass of Elecond (registered trademark) PQ-50B supplied by Soken Chemical & Engineering Co., Ltd., which is a cationic antistatic agent, was used as said antistatic agent, the same procedure as for the preparation of paint 1 for coat layer formation was carried out to provide paint 10 for coat layer formation.

(Preparation of paint 11 for coat layer formation)

Except that a coating material (solid content of 40 mass%) containing an acrylic resin produced from methyl methacrylic acid and 2-hydroxyethyl methacrylate was used instead of HALS Hybrid Polymer (registered trademark) BK1 (solid content of 40 mass%), the same procedure as for the preparation of paint 1 for coat layer formation was carried out to provide paint 11 for coat layer formation.

(Preparation of adhesive for dry lamination)

A mixture of 16 parts of a dry lamination material (Dicdry (registered trademark) LX-903 supplied by DIC Corporation), 2 parts by mass of a curing agent (KL-75 supplied by Dainippon Ink and Chemicals, Inc.), and 29.5 parts by mass of ethyl acetate was weighed out and stirred for 15 minutes to provide an adhesive for dry lamination with a solid content of 20%.

(Preparation of paint for adhesive layer formation)

A mixture of 12 parts by mass of a dry lamination material (polyester polyurethane resin, Takelac (registered trademark) A-310 supplied by Mitsui Chemicals Polyurethanes, Inc.), 1 part by mass of an aromatic polyisocyanate resin (Takenate (registered trademark) A-3 supplied by Mitsui Chemicals Polyurethanes, Inc.), and 212 parts by mass of ethyl acetate was weighed out and stirred for 15 minutes to provide a paint for adhesive layer formation with a solid content of 3 mass%.

(Preparation of paint for heat-bonding resin layer formation)

A mixture of 20 parts by mass of an aqueous emulsion paint containing EVA type ternary copolymer resin (Aquatex (registered trademark) MC-3800 supplied by CSC Co., Ltd.), 10.8 parts by mass of isopropyl alcohol, and 22.6 parts by mass of water was weighed out and stirred for 15 minutes to provide a paint for heat-bonding resin layer formation with a solid content of 15 mass%.

(Example 1)

The base film used was a hydrolysis resistant polyethylene terephthalate film with a cyclic trimer content of 1 wt% or less (Lumiror (registered trademark) X10S (125 $\mu$m) supplied by Toray Industries, Inc.). Paint 1 for coat layer formation was spread with a wire bar over one side of this base film and dried at 150˚C for 30 seconds to form a coat layer (resin layer) having a coating weight of 3.0 g/m$^2$ after drying. Thus, film 1 for solar battery backside sealing sheet was produced.

(Example 2)

Except for spreading paint 2 for coat layer formation instead of paint 1 for coat layer formation, the same procedure as in Example 1 was carried out to produce film 2 for solar battery backside sealing sheet.

(Example 3)

Except for spreading paint 3 for coat layer formation instead of paint 1 for coat layer formation, the same procedure as in Example 1 was carried out to produce film 3 for solar battery backside sealing sheet.

(Example 4)

Except for spreading paint 4 for coat layer formation instead of paint 1 for coat layer formation, the same procedure as in Example 1 was carried out to produce film 4 for solar battery backside sealing sheet.

(Example 5)

Except for spreading paint 5 for coat layer formation instead of paint 1 for coat layer formation, the same procedure as in Example 1 was carried out to produce film 5 for solar battery backside sealing sheet.

(Example 6)

Except for spreading paint 6 for coat layer formation instead of paint 1 for coat layer formation, the same procedure as in Example 1 was carried out to produce film 6 for solar battery backside sealing sheet.

(Example 7)

Except for spreading paint 7 for coat layer formation instead of paint 1 for coat layer formation, the same procedure as in Example 1 was carried out to produce film 7 for solar battery backside sealing sheet.

(Comparative example 1)

Except for spreading paint 8 for coat layer formation instead of paint 1 for coat layer formation, the same procedure as in Example 1 was carried out to produce film 8 for solar battery backside sealing sheet.

(Comparative example 2)

Except for spreading paint 9 for coat layer formation instead of paint 1 for coat layer formation, the same procedure as in Example 1 was carried out to produce film 9 for solar battery backside sealing sheet.

(Comparative example 3)

Except for spreading paint 10 for coat layer formation instead of paint 1 for coat layer formation, the same procedure as in Example 1 was carried out to produce film 10 for solar battery backside sealing sheet.

(Comparative example 4)

Except for spreading paint 11 for coat layer formation instead of paint 1 for coat layer formation, the same procedure as in Example 1 was carried out to produce film 11 for solar battery backside sealing sheet.

(Comparative example 5)

Lumiror (registered trademark) X10S (supplied by Toray Industries, Inc., 125 $\mu$m) was used as film 12 for solar battery backside sealing sheet without forming a coat layer.

Characteristics of the films for solar battery backside sealing sheet produced above in Examples 1 to 7 and Comparative examples 1 to 5 were evaluated by the evaluation methods described above. Results are shown in Table 1.

(Comparison between Examples 1 to 7 and Comparative examples 1 to 3)

The coat layer in film 8 for solar battery backside sealing sheet produced in Comparative example 1 does not contain an antistatic agent. Accordingly, its surface resistance is a high $10^{14}\Omega/cm^2$ as compared with the values of light resistant films 1 to 7 produced in Examples 1 to 7, and film 8 for solar battery backside sealing sheet has a partial discharge voltage of 723V which is lower than that of light resistant films 1 to 7 produced in Examples 1 to 7. The coat layer in film 5 for solar battery backside sealing sheet produced in Example 5 did not contain an aliphatic polyisocyanate resin (crosslinking agent), and this film showed a higher partial discharge voltage than film 1 for solar battery backside sealing sheet produced in Example 1 which is different from the former only in this respect. It inferred that, being free from crosslinking agents, the coat film contains unreacted hydroxyl groups remaining in the acrylic polyol resin, and therefore, the coat film surface is highly hydrophilic and adsorbs much water, possibly leading to a lower surface resistance and a higher partial discharge voltage, although the high partial discharge voltage leads to a low solvent resistance. Similarly, the partial discharge voltage is higher for samples free from crosslinking agents also when a needle-like inorganic solid antistatic material is used as in Examples 6 and 7. On the other hand, the solvent resistance is low in all cases where the coat layer is free from crosslinking agents. In Example 6, the use of aliphatic polyisocyanate leads to a coat film with an improved solvent resistance, and the partial discharge voltage is not affected by the solvent resistance test. Though film 9 for solar battery backside sealing sheet produced in Comparative example 2 contains 0.5 parts by mass of an antistatic agent in the light resistant coat layer, this content is not large enough to affect the conductivity and surface resistance of the coat layer, and cannot serve to improve the partial discharge voltage of light resistant film 7. In film 10 for solar battery backside sealing sheet production produced in Comparative example 3, on the other hand, the light resistant coat layer contains 35 parts by mass of an antistatic agent, and accordingly, the content of the resin in the coat layer is very small, leading to a large decrease in the ultraviolet screening capability and a increase in the light transmittance at a wavelength of 360 nm. It is seen that a significant change in the appearance (color) was caused by ultraviolet irradiation.

(Comparison between Examples 1 to 7 and Comparative example 4)

In the coat layer of film 11 for solar battery backside sealing sheet produced in Comparative example 4, the acrylic resin, a major component of the coat layer, is not crosslinked with an ultraviolet absorber or a photostabilizing agent. Consequently, the coat layer does not have ultraviolet screening capability, and degradation of resin in the coat layer is caused by ultraviolet irradiation, leading not only to an insufficient contact strength between the base film and the coat layer, but also to degradation and yellowing of resin in the base film.

(Comparison between Examples 1 to 7 and Comparative example 5)

Film 12 for solar battery backside sealing sheet produced in Comparative example 5 (which is actually a film of Lumiror (registered trademark) X10S free from a coat layer) does not have ultraviolet screening capability, and it is free from a resin layer containing an antistatic agent to improve the partial discharge voltage. As a result, the partial discharge voltage was a low 707 V, and degradation and yellowing of the resin was caused by ultraviolet irradiation.

(Example 8)

An adhesive for dry lamination is spread with a wire bar over the opposite film surface to the coat layer side of film 1 for solar battery backside sealing sheet by the same procedures as in Example 1, and dried at 80˚C for 45 seconds to form an adhesive layer of 3.5 $\mu$m. Then, a light reflective film, which is a white polyethylene terephthalate film of Lumiror (registered trademark) E20F (50 $\mu$m) supplied by Toray Industries, Inc., is bonded to the adhesive layer using a hand roller. Furthermore, an adhesive for dry lamination is spread with a wire bar over the opposite film surface to the light resistant coat layer side of this laminate film, and dried at 80˚C for 45 seconds to form an adhesive layer of 3.5 $\mu$m. Subsequently, an aluminum oxide-deposited polyethylene terephthalate film combined with a vapor barrier film (Barrier-Locks (registered trademark) 1031HGTS (12 $\mu$m) supplied by Toray Advanced Film Co., Ltd.) is prepared, and a paint for adhesive layer formation and a paint for heat-bonding resin layer formation are spread in this order with a double-head tandem type direct gravure coater under the conditions described below on the opposite side to the deposited aluminum oxide layer. The two films are bonded to each other with the deposited aluminum oxide side of the latter facing to the adhesive layer of the former using a hand roller. This procedure is carried out to produce three films, which are combined into a sheet and aged for three days in an oven heat at 40˚C to provide solar battery backside sealing sheet 1.

- Adhesive layer coating conditions: dried film thickness 0.2 $\mu$m, drying oven temperature setting 120˚C

- Heat-bonding resin layer coating conditions: dried film thickness 1.0 $\mu$m, drying oven temperature setting 100˚C

- Coating speed: 100 m/min

- Aging: aging at 40˚C for 2 days after coating and winding up

(Example 9)

Except that a polyethylene film (50 $\mu$m) (supplied by Toray Advanced Film Co., Ltd.) that can develop a strong contact with EVA sheets was used instead of the vapor barrier film, the same procedure as in Example 8 was carried out to produce solar battery backside sealing sheet 2.

(Example 10)

Except that film 6 for solar battery backside sealing sheet was used instead of film 1 for solar battery backside sealing sheet, the same procedure as in Example 8 was carried out to produce solar battery backside sealing sheet 3.

(Example 11)

Except that film 6 for solar battery backside sealing sheet was used instead of film 1 for solar battery backside sealing sheet and that a white polyethylene film (100 $\mu$m) (supplied by Toray Advanced Film Co., Ltd.) was used instead of the vapor barrier film and light reflective film, the same procedure as in Example 8 was carried out to produce solar battery backside sealing sheet 4.

(Comparative example 6)

Except that film 8 for solar battery backside sealing sheet was used instead of film 1 for solar battery backside sealing sheet, the same procedure as in Example 8 was carried out to produce solar battery backside sealing sheet 5.

(Comparative example 7)

Except that film 11 for solar battery backside sealing sheet was used instead of film 1 for solar battery backside sealing sheet, the same procedure as in Example 8 was carried out to produce solar battery backside sealing sheet 6.

(Comparative example 8)

Except that film 12 for solar battery backside sealing sheet was used instead of film 1 for solar battery backside sealing sheet, the same procedure as in Example 8 was carried out to produce solar battery backside sealing sheet 7.

(Comparison between Examples 8 to 11 and Comparative example 6)

Solar battery backside sealing sheets 1 to 4 produced by the procedure described in Examples 8 to 11, respectively, all have a high partial discharge voltage of 1,000 V or more, can serve as good backside sealing sheets for solar cell modules at high system voltages. When ultraviolet rays are applied from the coat layer side, i.e. the outermost layer in the solar cell module, they do not affect the strength of contact between the base film and the coat layer, and little yellowing takes place in the coat layer and the base film. In the case of solar battery backside sealing sheet 5 produced by the procedure described in Comparative example 6, on the other hand, the coat layer located outermost does not contain an antistatic agent, and shows a low partial discharge voltage of 850 V, suggesting that it would not serve appropriately when used in a solar cell module required to operate at high system voltages.

(Comparison between Examples 8 to 10 and Comparative example 7)

In the case of solar battery backside sealing sheet 6 produced by the procedure described in Comparative example 7, the coat layer located outermost does not have ultraviolet screening capability as it is composed primarily of an acrylic resin that is not crosslinked with an ultraviolet absorber or a photostabilizing agent, and the resin suffers degradation and yellowing when irradiated with ultraviolet rays although it shows a high partial discharge voltage. If used for a long term under outdoor installation conditions, the sheet will be exposed to ultraviolet rays reflected from the ground surface, and in extreme cases, the film can suffer cracks and pinholes, possibly leading not only to loss of required sealing sheet characteristics including electrical insulating properties and moisture barrier properties, but also to impaired performance of the solar cell module. Therefore, this backside sealing sheet cannot be used in a solar cell module that is designed for use under such installation conditions.

(Comparison between Examples 8 to 10 and Comparative example 8)

Solar battery backside sealing sheet 7 produced by the procedure described in Comparative example 8 does not have an outermost coat layer that has ultraviolet screening capability or contains an antistatic agent. Accordingly, it is low in both partial discharge voltage and ultraviolet resistance. Therefore, this backside sealing sheet cannot serve appropriately in a solar cell module required to operate at high system voltages or in a solar cell module designed for use under installation conditions, such as outdoor locations, where it is exposed to ultraviolet rays reflected from the ground surface.

As clearly seen from the comparisons between Examples and Comparative examples described above, the method of the invention serves to produce films for solar battery backside sealing sheet and protect sheets for solar battery backside sealing that are high in light resistance and partial discharge voltage which is an indicator of electrical insulation performance.

According to a preferred embodiment of the invention, it is possible to produce a solar battery backside sealing sheet that develops a strong contact with a silicon cell filler layer, has high light reflectance and good vapor barrier properties, and enhances and maintains the performance of a solar cell module. At the same time, solar cell modules comprising the solar battery backside sealing sheet of the invention can be high in power generation efficiently as a result of the high light reflectance, and the solar cell modules are also high in durability.

Table 1-1

| Example No. | Film | Coat layer | | Solvent resistance (visual observation) | Base/coat contact strength | | | Ultraviolet screening capability (transmittance at wavelength 360 nm [%]) | | |
|---|---|---|---|---|---|---|---|---|---|---|
| | | Coating material | Coating weight [g/m$^2$] | | Initial | After moist heat test | After UV irradiation | Initial | After moist heat test | After UV irradiation |
| Example 1 | Light resistant film 1 | Paint 1 | 3.0 | ○ | ○ | ○ | ○ | 1 or less | 1 or less | 1 or less |
| Example 2 | Light resistant film 2 | Paint 2 | 2.9 | ○ | ○ | ○ | ○ | 1 or less | 1 or less | 1 or less |
| Example 3 | Light resistant film 3 | Paint 3 | 3.0 | ○ | ○ | ○ | ○ | 1 or less | 1 or less | 1 or less |
| Example 4 | Light resistant film 4 | Paint 4 | 3.0 | ○ | ○ | ○ | ○ | 1 or less | 1 or less | 1 or less |
| Example 5 | Light resistant film 5 | Paint 5 | 2.9 | × | ○ | ○ | ○ | 1 or less | 1 or less | 1 or less |
| Example 6 | Light resistant film 6 | Paint 6 | 3.0 | ○ | ○ | ○ | ○ | 1 or less | 1 or less | 1 or less |
| Example 7 | Light resistant film 7 | Paint 7 | 3.0 | × | ○ | ○ | ○ | 1 or less | 1 or less | 1 or less |
| Comparative example 1 | Light resistant film 8 | Paint 8 | 3.0 | ○ | ○ | ○ | ○ | 1 or less | 1 or less | 1 or less |
| Comparative example 2 | Light resistant film 9 | Paint 9 | 2.9 | ○ | ○ | ○ | ○ | 1 or less | 1 or less | 1 or less |

(continued)

| Example No. | Film | Coat layer | | Solvent resistance (visual observation) | Base/coat contact strength | | | Ultraviolet screening capability (transmittance at wavelength 360 nm [%]) | | |
|---|---|---|---|---|---|---|---|---|---|---|
| | | Coating material | Coating weight [g/m²] | | Initial | After moist heat test | After UV irradiation | Initial | After moist heat test | After UV irradiation |
| Comparative example 3 | Light resistant film 10 | Paint 10 | 3.0 | ○ | ○ | × | x | 4 | 5 | 5 |
| Comparative example 4 | Light resistant film 11 | Paint 11 | 3.1 | ○ | ○ | × | × | 57 | 60 | 43 |
| Comparative example 5 | Light resistant -film 12 | - | - | - | - | - | - | 59 | 61 | 46 |

Table 1-2

| Example No. | film | Surface resistance Initial ($\Omega/\square$) | Partial discharge voltage [V] | | | | Ultraviolet resistance $\Delta b$ |
|---|---|---|---|---|---|---|---|
| | | Initial | Initial | After solvent resistance test | After moist heat test | After UV irradiation | |
| Example 1 | Light resistant film 1 | $10^{10}$ | 873 | 862 | 872 | 710 | 5.3 |
| Example 2 | Light resistant film 2 | $10^{13}$ | 797 | 789 | 787 | 715 | 6.7 |
| Example 3 | Light resistant film 3 | $10^{12}$ | 810 | 809 | 820 | 790 | 2.8 |
| Example 4 | Light resistant film 4 | $10^{11}$ | 823 | 822 | 810 | 750 | 2.3 |
| Example 5 | Light resistant film 5 | $10^{9}$ | 907 | 820 | 902 | 815 | 5.1 |
| Example 6 | Light resistant film 6 | $10^{8}$ | 967 | 912 | 978 | 950 | 2.3 |
| Example 7 | Light resistant film 7 | $10^{7}$ | 1237 | 1220 | 1130 | 1050 | 2.6 |
| Comparative example 1 | Light resistant film 8 | $10^{14}<$ | 723 | 721 | 710 | 715 | 2.3 |
| Comparative example 2 | Light resistant film 9 | $10^{14}<$ | 700 | 698 | 690 | 682 | 2.3 |
| Comparative example 3 | Light resistant film 10 | $10^{14}<$ | 790 | 781 | 763 | 712 | 18.7 |
| Comparative example 4 | Light resistant film 11 | $10^{10}$ | 855 | 888 | 872 | 693 | 30.1 |
| Comparative example 5 | Light resistant film 12 | $10^{14}<$ | 707 | - | 703 | 698 | 29.9 |

Table 2

| Example No. | Sheet | Sheet constitution | Light resistant coat layer | |
|---|---|---|---|---|
| | | | Coating material | Coating weight [g/m$^2$] |
| Example 8 | Solar battery backside sealing sheet 1 | heat-bonding resin layer/adhesive layerBarrier-Locks 1031HGTS/adhesive layer/Lumiror E20F/ adhesive layer/ Lumiror X10S/coat layer | Paint 1 | 3.0 |
| Example 9 | Solar battery backside sealing sheet 2 | polyethylene film/ adhesive layer/ Lumiror E20F/ adhesive layer/ Lumiror X10S/coat layer | Paint 1 | 2.9 |
| Example 10 | Solar battery backside sealing sheet 3 | heat-bonding resin layer/adhesive layerBarrier-Locks 1031 HGTS/adhesive layer/Lumiror E20F/ adhesive layer/ Lumiror X10S/coat layer | Paint 6 | 3.0 |
| Example11 | Solar battery backside sealing sheet 4 | white polyethylene film/adhesive layer/ Lumiror X10S/coat layer | Paint 6 | 3.0 |
| Comparative example 6 | Solar battery backside sealing sheet 5 | heat-bonding resin layer/adhesive layerBarrier-Locks 1031 HGTS/adhesive layer/Lumiror E20F/ adhesive layer/ Lumiror X10S/coat layer | Paint 8 | 3.0 |
| Comparative example 7 | Solar battery backside sealing sheet 6 | heat-bonding resin layer/adhesive layerBarrier-Locks 1031HGTS/adhesive layer/Lumiror E20F/ adhesive layer/ Lumiror X10S/coat layer | Paint 11 | 3.0 |
| Comparative example 8 | Solar battery backside sealing sheet 7 | heat-bonding resin layer/adhesive layerBarrier-Locks 1031HGTS/adhesive layer/Lumiror E20F/ adhesive layer/ Lumiror X10S | - | - |

Table 3

| Example No. | Sheet | EVA sheet contact strength | Light reflectance (600 nm) | Vapor transmittance (40˚C, 90%RH) | Surface resistance | Partial electrical discharge [V] | Ultraviolet resistance outermost layer $\Delta b$ |
|---|---|---|---|---|---|---|---|
| | | [N/50mm] | % | [g/m$^2$·day] | $\Omega/\square$ | | |
| Example 8 | Solar battery backside sealing sheet 1 | 390 | 52 | 0.4 | $10^9$ | 1050 | 5.3 |
| Example 9 | Solar battery backside sealing sheet 2 | 490 | 50 | 1.4 | $10^7$ | 1297 | 5.2 |
| Example 10 | Solar battery backside sealing sheet 3 | 390 | 52 | 0.4 | $10^6$ | 1335 | 2.6 |
| Example 11 | Solar battery backside sealing sheet 4 | 500 | 57 | 1.2 | $10^8$ | 1440 | 2.6 |
| Comparative example 6 | Solar battery backside sealing sheet 5 | 390 | 52 | 0.4 | $10^{11}$ | 850 | 2.3 |
| Comparative example 7 | Solar battery backside sealing sheet 6 | 390 | 52 | 0.4 | $10^8$ | 1038 | 30.2 |
| Comparative example 8 | Solar battery backside sealing sheet 7 | 390 | 51 | 0.4 | $10^{11}$ | 846 | 29.9 |

Industrial applicability

The solar battery backside sealing sheet of the invention is high in light resistance and partial discharge voltage which is an indicator of electrical insulation performance and able to work effectively in solar cell modules, indicating the usefulness of the solar battery backside sealing sheet of the invention and solar cell modules made thereof.

**Claims**

1. A film for solar battery backside sealing sheet comprising a resin layer containing a resin produced by copolymerizing an acrylic polyol resin, an ultraviolet absorber, and a photostabilizing agent, along with an antistatic agent, that is laminated to at least one side of a base film, wherein the antistatic agent in the resin layer accounts for 1 to 30 parts by mass relative to 100 parts by mass of the resin produced by copolymerizing an acrylic polyol resin, an ultraviolet absorber, and a photostabilizing agent

2. A film for solar battery backside sealing sheet as claimed in claim 1 wherein said antistatic agent is a cationic antistatic agent and/or an inorganic solid conductive material

3. A film for solar battery backside sealing sheet as claimed in claim 2 wherein said antistatic agent is an inorganic solid conductive material, and said solid conductive material consists of needle-like inorganic fiber provided on an electrically conductive layer

4. A film for solar battery backside sealing sheet as claimed in claim 3 wherein said inorganic fiber is of titanium oxide

5. A film for solar battery backside sealing sheet as claimed in claim 1 wherein said resin layer contains at least one polyisocyanate resin selected from the group of aliphatic isocyanate resin, alicyclic isocyanate resin, and araliphatic isocyanate resin

6. A solar battery backside sealing sheet comprising a film for solar battery backside sealing sheet as claimed in claim 5 wherein said film is covered with at least one other film

7. A solar battery backside sealing sheet as claimed in claim 6 wherein said at least one other film is formed on the opposite side to said resin layer side of a film for solar battery backside sealing sheet

8. A solar cell module comprising a solar battery backside sealing sheet as claimed in claim 6 bonded to the silicon cell filler layer side of the solar cell module

<table>
<tr><td colspan="2" style="text-align:center">**INTERNATIONAL SEARCH REPORT**</td><td colspan="2">International application No.<br>PCT/JP2009/069353</td></tr>
</table>

A. CLASSIFICATION OF SUBJECT MATTER
*H01L31/042*(2006.01)i

According to International Patent Classification (IPC) or to both national classification and IPC

B. FIELDS SEARCHED

Minimum documentation searched (classification system followed by classification symbols)
H01L31/042

Documentation searched other than minimum documentation to the extent that such documents are included in the fields searched

| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2006-319250 A (Keiwa Inc.),<br>24 November 2006 (24.11.2006),<br>paragraphs [0025], [0032], [0038] to [0039],<br>[0046], [0058] to [0059], [0066], [0090]<br>(Family: none) | 1-8 |
| Y | JP 1-261409 A (Nippon Shokubai Kagaku Kogyo<br>Co., Ltd.),<br>18 October 1989 (18.10.1989),<br>claim 1<br>& US 5239028 A    & EP 337744 A2 | 1-8 |
| Y | JP 2005-314561 A (Chuden-Kogyo Co., Ltd.),<br>10 November 2005 (10.11.2005),<br>paragraphs [0024] to [0025]<br>(Family: none) | 3-4 |

☒ Further documents are listed in the continuation of Box C.    ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| Date of the actual completion of the international search<br>14 January, 2010 (14.01.10) | Date of mailing of the international search report<br>26 January, 2010 (26.01.10) |
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

| International application No. |
|---|
| PCT/JP2009/069353 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2008-177181 A  (Dueller Corp.),<br>31 July 2008 (31.07.2008),<br>paragraph [0029]<br>& WO 2008/087690 A1 | 1-8 |
| A | JP 2002-26354 A  (Toray Industries, Inc.),<br>25 January 2002 (25.01.2002),<br>paragraph [0020]<br>(Family: none) | 1-8 |
| A | JP 2002-307591 A  (Nippon Shokubai Co., Ltd.),<br>23 October 2002 (23.10.2002),<br>paragraphs [0029], [0033]<br>(Family: none) | 1-8 |
| A | JP 2006-326971 A  (Toray Industries, Inc.),<br>07 December 2006 (07.12.2006),<br>paragraphs [0011], [0042], [0064] to [0069]<br>(Family: none) | 1-8 |
| A | JP 2007-128943 A  (Toray Industries, Inc.),<br>24 May 2007 (24.05.2007),<br>paragraphs [0019], [0043]<br>(Family: none) | 1-8 |

Form PCT/ISA/210 (continuation of second sheet) (April 2007)

**REFERENCES CITED IN THE DESCRIPTION**

**Patent documents cited in the description**

- JP 2002100788 A
- JP 2006253264 A
- JP 2002090515 A
- JP HEI0753217 B